# EUROPÄISCHE PATENTSCHRIFT

(11) **EP 4 508 687 B1**
(45) Veröffentlichungstag und Bekanntmachung des Hinweises auf die Patenterteilung: **05.11.2025**
(21) Anmeldenummer: 23702292.6
(22) Anmeldetag: 25.01.2023
(51) Int. Cl.: H02S 40/10, H10F 19/80, F24S 40/20, F24S 80/52, C09D 5/00

(54) **VERFAHREN ZUR ERHÖHUNG DES WIRKUNGSGRADES EINES SOLARMODULS ODER EINES SOLARKOLLEKTORS**
METHOD FOR INCREASING THE EFFICIENCY OF A SOLAR MODULE OR A SOLAR COLLECTOR
PROCÉDÉ PERMETTANT D'AUGMENTER L'EFFICACITÉ D'UN MODULE SOLAIRE OU D'UN CAPTEUR SOLAIRE

(30) Priorität: 14.04.2022 DE 102022109298
(43) Veröffentlichungstag der Anmeldung: 19.02.2025
(73) Patentinhaber: GELITA AG, 69412 Eberbach (DE)
(72) Erfinder: VAN ELSACKER, Michael, 69412 Eberbach (DE); LIPP, Tonja, Princeton, New Jersey 08540 (US); HAUSMANNS, Stephan, 68199 Mannheim (DE); RITTEREISER, Nina, 69429 Waldbrunn-Oberdielbach (DE); REIHMANN, Matthias, 69502 Hemsbach (DE); KÖHLER, Berthold, 69151 Neckargemünd (DE)
(74) Vertreter: Hoeger, Stellrecht & Partner Patentanwälte mbB
(86) Internationale Anmeldenummer: PCT/EP2023/051815
(87) Internationale Veröffentlichungsnummer: WO 2023/198332

(56) Entgegenhaltungen:
- EP-A1- 3 992 255
- WO-A1-2020/261121
- US-A1- 2016 130 447
- BUKHARI FARWAH ET AL: "Abrasion resistance of hydrophobic, anti-soiling coatings for solar cover glass", 2020 47TH IEEE PHOTOVOLTAIC SPECIALISTS CONFERENCE (PVSC), IEEE, 15 June 2020 (2020-06-15), pages 1866 - 1870, XP033870667, DOI: 10.1109/PVSC45281.2020.9300904

## Beschreibung

Die vorliegende Erfindung betrifft ein Verfahren zur Erhöhung des Wirkungsgrades eines Solarmoduls oder eines Solarkollektors, wobei das Solarmodul oder der Solarkollektor eine Glasscheibe auf der sonnenzugewandten Seite aufweist.

Die Nutzung von Photovoltaikanlagen liefert neben der Windkraft einen wesentlichen Beitrag zur Erzeugung von elektrischer Energie aus erneuerbaren Energiequellen. Im Rahmen der weltweiten Bemühungen, die Energiegewinnung aus fossilen Brennstoffen soweit wie möglich zu verringern, wird der Nutzung von Photovoltaikanlagen eine weiter steigende Bedeutung zukommen. Dies gilt insbesondere für große Photovoltaikanlagen in Gegenden wie z.B. den Wüstenregionen Nordafrikas, in denen aufgrund der klimatischen Bedingungen eine besonders hohe Ausbeute an Sonneneinstrahlung möglich ist.

Die in einer Photovoltaikanlage eingesetzten Solarmodule (Photovoltaikmodule) weisen fast immer einen Aufbau auf, bei dem die photovoltaisch aktiven Solarzellen zum Schutz unter einer Glasscheibe angeordnet sind. Diese Glasscheibe auf der sonnenzugewandten Seite des Solarmoduls ist durchlässig für den durch die Solarzellen nutzbaren Spektralanteil des Sonnenlichts, der in der Regel innerhalb eines Bereichs von etwa 300 nm bis etwa 1.100 nm liegt.

Durch Schmutzablagerungen auf der Oberfläche der Glasscheibe, die nach einer gewissen Betriebsdauer einer Photovoltaikanlage unweigerlich auftreten, kommt es zu einer Verringerung des Wirkungsgrades der Solarmodule. Um dem entgegenzuwirken, ist eine Reinigung der Solarmodule in bestimmten Zeitabständen erforderlich, abhängig von den Umgebungsbedingungen und dem daraus resultierenden Grad der Verschmutzung. Gerade bei großen Photovoltaikanlagen in Regionen mit einer hohen Sonnenausbeute, also insbesondere in Wüstenregionen, ist die Reinigung der Solarmodule nicht nur aufwendig, sondern aufgrund des Wasserverbrauchs auch im Hinblick auf die Schonung von Ressourcen problematisch. Durch die Ablagerung von Staub auf den Solarmodulen kann sich deren Wirkungsgrad innerhalb eines Monats um bis zu 30% verringern. Die Abreinigung des Staubes mit Wasser kann andererseits einen erheblichen Anteil der Betriebskosten verursachen, wodurch die wirtschaftliche Profitabilität sinkt.

Die für Solarmodule beschriebene Problematik der Verschmutzung der Glasscheibe betrifft in entsprechender Weise auch Sonnenkollektoren (Solarkollektoren), die in Solarthermieanlagen zur Erzeugung von Wärmeenergie aus Sonnenlicht eingesetzt werden (insbesondere zur Warmwasserbereitung oder Heizungsunterstützung). Auch derartige Sonnenkollektoren umfassen eine Glasscheibe als Abdeckung auf der sonnenzugewandten Seite. US 2016/130447 A1 offenbart die Verwendung einer wässrigen Lösung zur Erhöhung des Wirkungsgrades eines Solarmoduls, wobei die wässrige Lösung auf eine sonnenzugewandte Glasscheibe des Moduls aufgebracht und anschließend trocknen gelassen wird.

Der Erfindung liegt daher die Aufgabe zugrunde, angesichts der vorstehend beschriebenen Problematik eine Möglichkeit zur Erhöhung des Wirkungsgrades eines Solarmoduls oder eines Solarkollektors vorzuschlagen.

Diese Aufgabe wird bei dem Verfahren der eingangs genannten Art erfindungsgemäß gelöst durch die Schritte:
- Aufbringen einer wässrigen Lösung von Kollagenhydrolysat auf die Glasscheibe; und
- Trocknenlassen der wässrigen Lösung.

Durch das erfindungsgemäße Verfahren wird eine Schutzschicht aus Kollagenhydrolysat auf der Oberfläche der Glasscheibe gebildet. Es wurde festgestellt, dass durch diese Schutzschicht die Ablagerung von Schmutzpartikeln auf der Oberfläche vermindert bzw. die Entfernung der Schmutzpartikel bei nachfolgenden Reinigungen erleichtert wird. Im Ergebnis bewirkt das erfindungsgemäße Verfahren somit eine Erhöhung des Wirkungsgrades des Solarmoduls oder Solarkollektors durch einen geringeren Verschmutzungsgrad. Andererseits verringert sich durch die Anwendung des erfindungsgemäßen Verfahrens der erforderliche Reinigungsaufwand, um einen bestimmten Wirkungsgrad des Solarmoduls oder Solarkollektors zu erreichen.

Das erfindungsgemäße Verfahren ist mit besonderem Vorteil auch bei ganz oder teilweise transparenten Solarmodulen einsetzbar. Hierbei handelt es sich insbesondere um Solarmodule, bei denen die photovoltaisch aktiven Solarzellen in die Glasscheibe integriert sind. Solche transparenten Solarmodule haben einen potentiell großen Einsatzbereich als Fensterverglasung bei Gebäuden.

Kollagenhydrolysat, das im Rahmen der Erfindung eingesetzt wird, entsteht bei der chemischen oder enzymatischen Hydrolyse des tierischen Strukturproteins Kollagen, entweder durch direkte Hydrolyse des Kollagens oder über den Zwischenschritt von Gelatine. Im Gegensatz zu Gelatine, die bei Raumtemperatur ein Hydrogel bildet, hat Kollagenhydrolysat aufgrund seines geringeren Molekulargewichts keine Fähigkeit zur Gelbildung, sondern ist bei Raumtemperatur wasserlöslich.

Überraschenderweise bewirkt die durch das erfindungsgemäße Verfahren aufgebrachte Schutzschicht keine Verschlechterung des Wirkungsgrades des Solarmoduls durch eine Lichtabsorption des Kollagenhydrolysats im photovoltaisch nutzbaren Wellenlängenbereich des Sonnenlichts. Dies ist insofern nicht selbstverständlich, als für Beschichtungen auf Basis von Gelatine eine Lichtschutzwirkung bekannt ist, z.B. beim Schutz von Druckfarben vor dem Ausbleichen (vgl. Berthold Köhler: "Light Stability of Gelatine Coatings", Proceedings of International Congress of Imaging Sience 2002, Tokyo, Seite 369-370). Da die Peptide des Kollagenhydrolysats naturgemäß dieselbe Aminosäurezusammensetzung aufweisen wie die Polypeptide der Gelatine, ist von einem vergleichbaren Absorptionsverhalten auszugehen. Für die Absorption sind hierbei insbesondere die aromatischen Aminosäuren Tyrosin, Phenylalanin und Histidin relevant.

Das Aufbringen der wässrigen Lösung von Kollagenhydrolysat auf die Glasscheibe kann mit jeder geeigneten Auftragsmethode erfolgen, wobei eine möglichst gleichmäßige Verteilung über die gesamte Fläche der Glasscheibe anzustreben ist. Bevorzugt wird die wässrige Lösung auf die Glasscheibe aufgestrichen (z.B. mittels eines saugfähigen Applikators), aufgesprüht (mit oder ohne Druck) oder aufgegossen. Die bevorzugte Auftragsmethode kann auch unter Berücksichtigung der Größe und Anordnung (z.B. horizontal oder geneigt) des Solarmoduls oder Solarkollektors ausgewählt werden.

Die Auftragsmenge pro Flächeneinheit sollte ausreichend groß sein, um eine gleichmäßige Verteilung der wässrigen Lösung auf der Glasscheibe zu ermöglichen, und andererseits klein genug, damit nicht zu viel überschüssige Lösung von der Glasscheibe abfließt.

Die wässrige Lösung umfasst günstigerweise einen Anteil an Kollagenhydrolysat von ca. 0,5 Gew.% oder mehr, bevorzugt von ca. 0,7 Gew.% oder mehr, weiter bevorzugt von ca. 0,9 Gew.% oder mehr. Es hat sich gezeigt, dass mit dieser Konzentration an Kollagenhydrolysat bereits ein deutlicher Effekt erzielt werden kann.

Günstigerweise umfasst die wässrige Lösung einen Anteil an Kollagenhydrolysat von bis zu 10 Gew.%, bevorzugt von bis zu ca. 5 Gew.%, weiter bevorzugt von bis zu ca. 2,5 Gew.%.

Besonders bevorzugt ist z.B. eine wässrige Lösung mit einem Anteil von ca. 1 bis ca. 2 Gew.% Kollagenhydrolysat.

Wie bereits oben angesprochen, ist das in dem erfindungsgemäßen Verfahren eingesetzte Kollagenhydrolysat insbesondere durch chemische oder enzymatische Hydrolyse von kollagenhaltigen tierischen Ausgangsmaterialien hergestellt. Das tierische Ausgangsmaterial ist bevorzugt ausgewählt aus Haut oder Knochen von Wirbeltieren, insbesondere von Rindern, Schweinen oder Schafen. Besonders bevorzugt ist die Herstellung des Kollagenhydrolysats durch enzymatische Hydrolyse von Gelatine, insbesondere unter Verwendung von einer oder mehreren Endopeptidasen.

Kollagenhydrolysat liegt typischerweise als Gemisch von Peptiden mit einer bestimmten Molekulargewichtsverteilung vor, wobei diese Molekulargewichtsverteilung durch die jeweiligen Hydrolysebedingungen beeinflusst werden kann (insbesondere durch die eingesetzten Enzyme, Hydrolysedauer, Temperatur und pH-Wert). Das Kollagenhydrolysat weist typischerweise ein mittleres Molekulargewicht von ca. 500 bis ca. 25.000 Da auf, bevorzugt von ca. 1.000 bis ca. 12.000 Da, weiter bevorzugt von ca. 2.000 bis ca. 6.000 Da. Diese Angaben beziehen sich stets auf das gewichtsmittlere Molekulargewicht, welches mittels Gelpermeationschromatographie bestimmt wird.

Optional kann die wässrige Lösung, die auf die Glasoberfläche aufgebracht wird, neben dem Kollagenhydrolysat weitere Komponenten umfassen. Gemäß einer vorteilhaften Ausführungsform der Erfindung umfasst die wässrige Lösung ferner ein oder mehrere Tenside, bevorzugt in einem Anteil von ca. 0,5 bis ca. 2,0 Gew.%. Eine solche Lösung kann dann gleichzeitig zur Reinigung des Solarmoduls oder Solarkollektors verwendet werden. Insbesondere kann die wässrige Lösung als konventionelles Reinigungsmittel für Glasoberflächen formuliert sein, welches zusätzlich Kollagenhydrolysat umfasst.

Das Tensid oder die Tenside sind bevorzugt ausgewählt aus nicht-ionischen, anionischen und amphoteren Tensiden. Neben den Tensiden kann die wässrige Lösung dann auch weitere reinigungsaktive Komponenten umfassen, wie z.B. Komplexbildner, und/oder Additive wie z.B. pH-Regulatoren und Konservierungsmittel.

Nach dem Aufbringen der wässrigen Lösung von Kollagenhydrolysat wird diese trocknen gelassen, um die Schutzschicht aus Kollagenhydrolysat auf der Glasscheibe auszubilden. Das Trocknen der wässrigen Lösung erfolgt dabei typischerweise innerhalb von wenigen Minuten, insbesondere durch Sonneneinstrahlung.

Gemäß einer bevorzugten Ausführungsform umfasst das erfindungsgemäße Verfahren das wiederholte Aufbringen und Trocknenlassen der wässrigen Lösung von Kollagenhydrolysat auf die Glasscheibe. Bevorzugt erfolgt das Aufbringen und Trocknenlassen der wässrigen Lösung in zeitlichen Abständen von mehreren Tagen bis mehreren Wochen, in Abhängigkeit von den jeweiligen Bedingungen, insbesondere der Schmutzbelastung der Solarmodule oder Solarkollektoren.

Günstigerweise wird jeweils vor dem Aufbringen der wässrigen Lösung von Kollagenhydrolysat die Glasscheibe gereinigt. Zwischen den Reinigungszyklen wird durch die Schutzschicht aus Kollagenhydrolysat die Ablagerung von Schmutzpartikeln auf der Glasscheibe verringert, so dass die Reinigung weniger häufig und/oder mit geringerer Intensität durchgeführt werden muss, um einen mindestens gleichbleibenden Wirkungsgrad des Solarmoduls oder Solarkollektors zu reichen, als dies ohne die Anwendung des erfindungsgemäßen Verfahrens der Fall wäre.

Gemäß einem weiteren Aspekt betrifft die Erfindung auch die Verwendung von Kollagenhydrolysat zur Erhöhung des Wirkungsgrades eines Solarmoduls oder eines Solarkollektors, wobei das Kollagenhydrolysat in Form einer wässrigen Lösung auf eine sonnenzugewandte Seite des Solarmoduls oder Solarkollektors aufgebracht und die wässrige Lösung anschließend trocknen gelöassen wird.

Vorteile und bevorzugte Ausführungsformen der erfindungsgemäßen Verwendung wurden bereits im Zusammenhang mit dem erfindungsgemäßen Verfahren erläutert.

Die nachfolgenden Beispiele dienen der näheren Erläuterung der Erfindung, ohne diese in irgendeiner Weise zu beschränken.

Es zeigen im Einzelnen:
- Figur 1:: Transmissionsspektren von Quarzküvetten nach mehrfachem Aufbringen und Trocknenlassen einer wässrigen Lösung von Kollagenhydrolysat;
- Figur 2A:: fotografische Darstellung von Objektträgern nach Beaufschlagung mit Testschmutz und Abreinigung mit Wasser;
- Figur 2B:: fotografische Darstellung von Objektträgern nach Vorbehandlung mit Kollagenhydrolysatlösung, Beaufschlagung mit Testschmutz und Abreinigung mit Kollagenhydrolysatlösung;
- Figur 3A:: fotografische Darstellung von Objektträgern nach Vorbehandlung mit Glasreiniger, Beaufschlagung mit Testschmutz und Abreinigung mit Wasser; und
- Figur 3B:: fotografische Darstellung von Objektträgern nach Vorbehandlung mit Glasreiniger mit Kollagenhydrolysat, Beaufschlagung mit Testschmutz und Abreinigung mit Wasser.

### Beispiele

### 1. Änderung der Transmission von Glas durch Kollagenhydrolysat

Es wurde folgender Vorversuch durchgeführt, um zu zeigen, dass sich mit dem erfindungsgemäßen Verfahren eine Kollagenhydrolysatschicht auf einer Glasoberfläche erzeugen lässt, und um den Effekt dieser Kollagenhydrolysatschicht auf die Transmission im Wellenlängenbereich von 190 bis 800 nm zu bestimmen:
Drei Küvetten aus Quarzglas wurden mit einer wässrigen Lösung gefüllt, die 1 Gew.% eines Kollagenhydrolysats mit einem mittleren Molekulargewicht von ca. 3.000 Da enthielt. Dieses Kollagenhydrolysat wird von der Anmelderin GELITA AG als 50%ige Lösung unter der Bezeichnung NOVOTEC^{®} CB800 vertrieben. Nach einer Minute wurde die Lösung aus den Küvetten entfernt und diese für ca. 24 Stunden bei Raumtemperatur trocknen gelassen.

Nach dem Trocknen wurde mit einem UV/VIS-Photometer die Transmission der drei Testküvetten sowie als Referenz einer leeren, unbehandelten Küvette im Wellenlängenbereich von 190 bis 800 nm gemessen. Anschließend wurde dieselbe Vorgehensweise dreimal wiederholt (d.h. Befüllen der Küvetten mit Kollagenhydrolysatlösung, Entleeren der Küvetten nach einer Minute, Messung der Transmission nach einer Trocknungszeit von ca. 24 Stunden).

Um auch die Entfernung der Kollagenhydrolysatschicht durch Waschen mit Wasser zu untersuchen, wurden die drei Testküvetten mit demineralisiertem Wasser gefüllt, dieses nach einer Minute entfernt und die Küvetten wieder für ca. 24 Stunden trocknen gelassen. Anschließend wurde die Transmission gemessen wie oben beschrieben, und die gesamte Prozedur wiederum dreimal wiederholt.

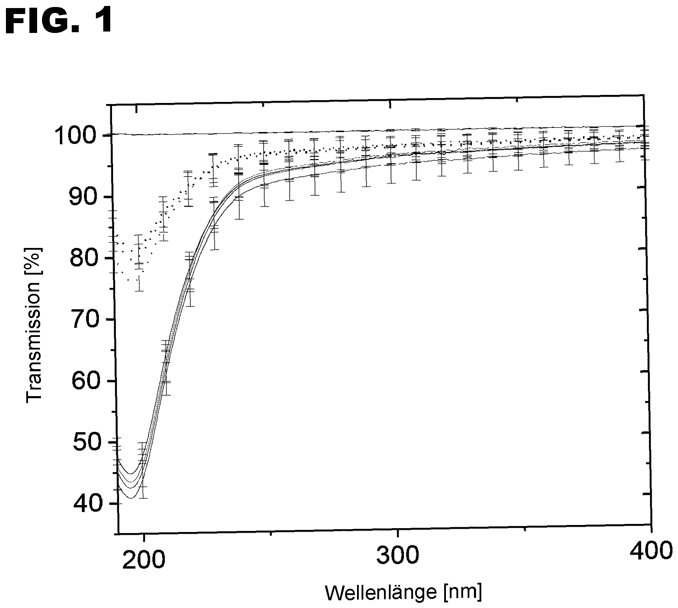

In der Figur 1 sind die gemessenen Transmissionsspektren der drei Testküvetten (Mittelwert und Standardabweichung) nach den jeweiligen Behandlungsschritten im Wellenlängenbereich von 190 bis 400 nm dargestellt. Die durchgezogenen Linien sind die Spektren nach den vier Behandlungsschritten mit Kollagenhydrolysatlösung, die gepunkteten Linien sind die Spektren nach den vier Waschschritten mit demineralisiertem Wasser. Die Transmission der Referenzküvette beträgt im gesamten Wellenlängenbereich 100%.

Die Auswertung der Spektren zeigt zum einen, dass sich bereits nach dem ersten Behandlungsschritt eine Kollagenhydrolysatschicht auf der Oberfläche der Quarzglasküvetten gebildet hat, die ein Absorptionsmaximum im Bereich zwischen 190 und 200 nm aufweist. Da die Spektren nach den vier Behandlungsschritten im Wesentlichen identisch sind, erfolgt offensichtlich kein weiterer Aufbau der Kollagenhydrolysatschicht durch zusätzliche Behandlungen, sondern es tritt bereits nach der ersten Behandlung mit einer wässrigen Lösung von Kollagenhydrolysat eine Art Sättigung der Oberfläche ein.

Die Spektren der Testküvetten nach den vier Reinigungsschritten liegen ebenfalls sehr eng beieinander. Die höhere Transmission im Vergleich zu den behandelten Testküvetten zeigt, dass bereits durch den ersten Reinigungsschritt die Kollagenhydrolysatschicht teilweise entfernt wird, jedoch zu etwa einem Drittel erhalten bleibt. Dieser Restanteil der Kollagenhydrolysatschicht ändert sich auch durch die nachfolgenden drei Waschschritte nur unwesentlich.

Die Ergebnisse zeigen andererseits, dass die Kollagenhydrolysatschicht keinen wesentlichen Einfluss auf die Transmission des Glases in dem durch Solarzellen nutzbaren Spektralbereich oberhalb von etwa 300 nm hat. Die Transmission der behandelten Küvetten liegt in diesem Bereich bei etwa 95% oder mehr. Im Wellenlängenbereich von 400 bis 800 nm, der in der Figur 1 nicht dargestellt ist, nähern sich alle Spektren weiter dem Wert von 100% an.

### 2. Reinigung von Glasscheiben nach Vorbehandlung mit Kollagenhydrolysatlösung im Vergleich zu Wasser

Um den Effekt des erfindungsgemäßen Verfahrens bei der Reinigung von Glasscheiben zu demonstrieren, wurden folgende Versuche durchgeführt:
Als Glasscheiben wurden Objektträger verwendet. Jeweils fünf Objektträger wurden mit Spülmittel und Leitungswasser gereinigt, demineralisiertem Wasser nachgespült und bei Raumtemperatur getrocknet. Die gereinigten Objektträger wurden mit einem Photometer auf identische Spektren im Wellenlängenbereich von 350 bis 800 nm geprüft, wobei die Transmission im gesamten Bereich durchgehend bei ca. 90% lag.

Die Objektträger wurden in eine wässrige Lösung mit 1 Gew.% Kollagenhydrolysat (erfindungsgemäße Proben) bzw. in demineralisiertes Wasser (Vergleichsproben) getaucht und darin fünf Minuten bei Raumtemperatur gelagert. Es wurde dasselbe Kollagenhydrolysat eingesetzt wie im Beispiel 1 (NOVOTEC^{®} CB800). Nach dem Entnehmen wurden die Objektträger bei Raumtemperatur getrocknet.

Die vorbehandelten Objektträger wurden in eine Testschmutz-Lösung getaucht und darin fünf Minuten gelagert. Hierfür wurde eine Standardschmutz-Lösung gemäß dem Kalkseifenentfernbarkeitstest des Industrieverbandes Körperpflege und Waschmittel e.V. verwendet. Nach dem Entnehmen wurden die Objektträger bei Raumtemperatur getrocknet und anschließend für drei Stunden bei 50 °C gelagert, um eine Alterung des Schmutzes zu simulieren.

Nach dem Abkühlen wurden die Objektträger in einer wässrigen Lösung mit 1 Gew.% Kollagenhydrolysat (erfindungsgemäße Proben) bzw. in demineralisiertem Wasser (Vergleichsproben) geschwenkt und dann bei Raumtemperatur getrocknet.

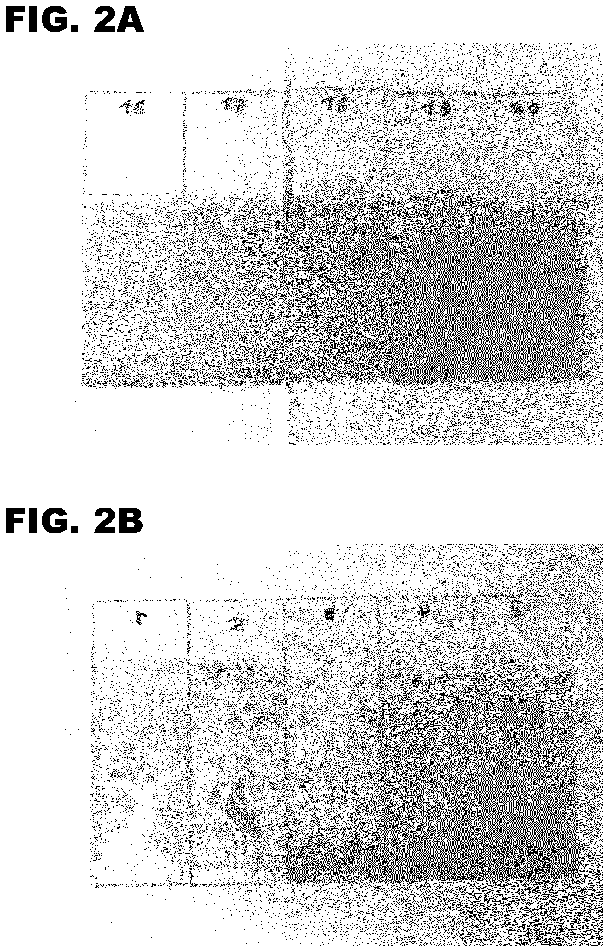

Die Figur 2A zeigt eine fotografische Darstellung der fünf Objektträger der Vergleichsproben, die Figur 2B zeigt eine fotografische Darstellung der fünf Objektträger der erfindungsgemäßen Proben.

Im direkten Vergleich zeigt sich ein deutlicher Unterschied zwischen den Vergleichsproben, bei denen fast keine Abreinigung des Testschmutzes erfolgt ist, und den erfindungsgemäßen Proben, bei denen erhebliche Anteile des Schmutzes abgereinigt werden konnten. Dieses Ergebnis konnte mit einem Photometer quantifiziert werden: Alle fünf Objektträger der Vergleichsproben zeigten im Bereich von 350 bis 800 nm keine Transmission (0%), während die Transmission bei den Objektträgern der erfindungsgemäßen Proben zwischen ca. 10% und ca. 50% lag.

Diese Ergebnisse zeigen deutlich, dass eine Behandlung von Glasscheiben mit Kollagenhydrolysat nach dem erfindungsgemäßen Verfahren wesentlich dazu beiträgt, eine Verschmutzung der Glasscheiben zu reduzieren bzw. die Abreinigung von Verschmutzungen zu erleichtern.

### 3. Reinigung von Glasscheiben nach Vorbehandlung mit Glasreiniger plus Kollagenhydrolysat im Vergleich zu Glasreiniger ohne Zusatz

Die im Beispiel 2 beschriebenen Versuche wurden mit folgenden Änderungen wiederholt:
Bei den fünf Objektträgern der Vergleichsproben erfolgte die Vorbehandlung mit einem Glasreiniger (Glass Window Cleaner, TER Group), mit 1 Gew.% eines nicht-ionischen Tensids als Hauptbestandteil, und die Abreinigung erfolgte mit demineralisiertem Wasser.

Bei den fünf Objektträgern der erfindungsgemäßen Proben erfolgte die Vorbehandlung mit dem o.g. Glasreiniger unter Zusatz von 1 Gew.% des Kollagenhydrolysats (NOVOTEC^{®} CB800), und die Abreinigung erfolgte mit demineralisiertem Wasser.

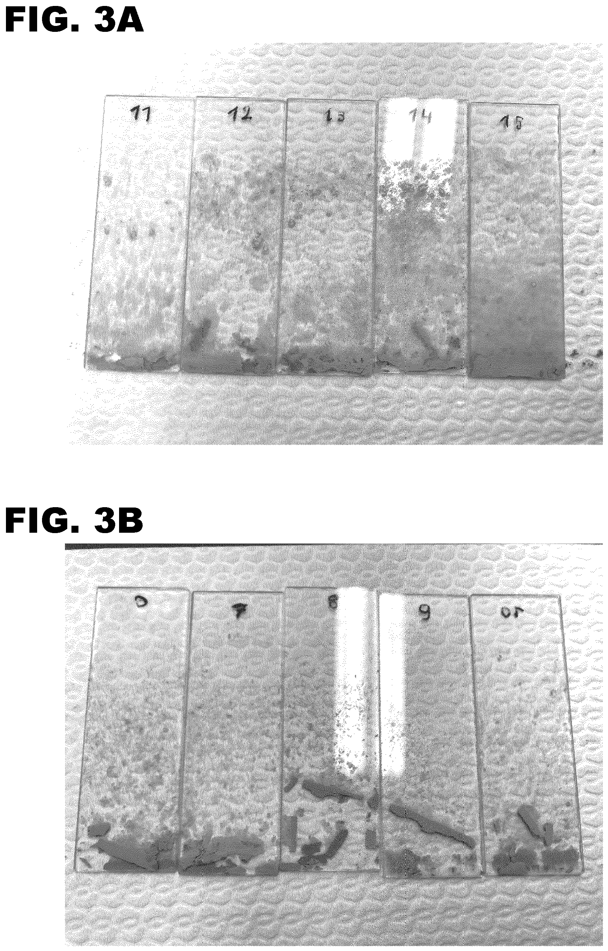

Die Figur 3A zeigt eine fotografische Darstellung der fünf Objektträger der Vergleichsproben, die Figur 3B zeigt eine fotografische Darstellung der fünf Objektträger der erfindungsgemäßen Proben.

Auch in diesem Fall zeigt ein direkter Vergleich zwischen den jeweiligen Objektträgern, dass die Vorbehandlung mit Kollagenhydrolysat (als Zusatz zu einem Glasreiniger) einen positiven Effekt auf die Abreinigung von Glasscheiben hat. Auch wenn bereits bei den Vergleichsproben eine deutliche Abreinigung zu erkennen ist (wenn auch sehr schwankend bei den einzelnen Proben), ist die Abreinigung bei den erfindungsgemäßen Proben gleichmäßig und wesentlich besser.

Die Messung mit dem Photometer ergab bei den einzelnen Objektträgern der Vergleichsproben eine strak schwankende Transmission zwischen ca. 20% und ca. 70%. Bei den erfindungsgemäßen Proben lag die Transmission in vier Fällen zwischen 40% und 50% und in einem Fall bei ca. 65%.

## Patentansprüche

1. Verfahren zur Erhöhung des Wirkungsgrades eines Solarmoduls oder eines Solarkollektors, wobei das Solarmodul oder der Solarkollektor eine Glasscheibe auf der sonnenzugewandten Seite aufweist,
**gekennzeichnet durch** die Schritte:
- Aufbringen einer wässrigen Lösung von Kollagenhydrolysat auf die Glasscheibe; und
- Trocknenlassen der wässrigen Lösung.

2. Verfahren nach Anspruch 1, wobei das Solarmodul ganz oder teilweise transparent ist, und wobei das Solarmodul bevorzugt Solarzellen umfasst, die in die Glasscheibe integriert sind.

3. Verfahren nach Anspruch 1 oder 2, wobei die wässrige Lösung auf die Glasscheibe aufgestrichen, aufgesprüht oder aufgegossen wird.

4. Verfahren nach einem der vorhergehenden Ansprüche, wobei die wässrige Lösung einen Anteil an Kollagenhydrolysat von ca. 0,5 Gew.% oder mehr umfasst, bevorzugt von ca. 0,7 Gew.% oder mehr, weiter bevorzugt von ca. 0,9 Gew.% oder mehr.

5. Verfahren nach einem der vorhergehenden Ansprüche, wobei die wässrige Lösung einen Anteil an Kollagenhydrolysat von bis zu 10 Gew.% umfasst, bevorzugt von bis zu ca. 5 Gew.%, weiter bevorzugt von bis zu ca. 2,5 Gew.%.

6. Verfahren nach einem der vorhergehenden Ansprüche, wobei das Kollagenhydrolysat durch chemische oder enzymatische Hydrolyse von kollagenhaltigen tierischen Ausgangsmaterialien hergestellt ist, bevorzugt aus Haut oder Knochen von Wirbeltieren, insbesondere von Rindern, Schweinen oder Schafen.

7. Verfahren nach einem der vorhergehenden Ansprüche, wobei das Kollagenhydrolysat ein mittleres Molekulargewicht von ca. 500 bis ca. 25.000 Da aufweist, bevorzugt von ca. 1.000 bis ca. 12.000 Da, weiter bevorzugt von ca. 2.000 bis ca. 6.000 Da.

8. Verfahren nach einem der vorhergehenden Ansprüche, wobei die wässrige Lösung ferner ein oder mehrere Tenside umfasst, bevorzugt in einem Anteil von ca. 0,5 bis ca. 2,0 Gew.%.

9. Verfahren nach Anspruch 8, wobei das oder die Tenside ausgewählt sind aus nicht-ionischen, anionischen und amphoteren Tensiden.

10. Verfahren nach Anspruch 8 oder 9, wobei die wässrige Lösung ferner ein oder mehrere Komponenten umfasst, die ausgewählt sind aus Komplexbildnern, pH-Regulatoren und Konservierungsmitteln.

11. Verfahren nach einem der vorhergehenden Ansprüche, wobei das Verfahren das wiederholte Aufbringen und Trocknenlassen der wässrigen Lösung von Kollagenhydrolysat auf die Glasscheibe umfasst, bevorzugt in zeitlichen Abständen von mehreren Tagen bis mehreren Wochen.

12. Verfahren nach Anspruch 11, wobei jeweils vor dem Aufbringen der wässrigen Lösung von Kollagenhydrolysat die Glasscheibe gereinigt wird.

13. Verwendung von Kollagenhydrolysat zur Erhöhung des Wirkungsgrades eines Solarmoduls oder eines Solarkollektors, wobei das Kollagenhydrolysat in Form einer wässrigen Lösung auf eine sonnenzugewandte Glasscheibe des Solarmoduls oder Solarkollektors aufgebracht und die wässrige Lösung anschließend trocknen gelassen wird.

## Claims

1. Method for increasing the efficiency of a solar module or a solar collector, wherein the solar module or the solar collector comprises a glass pane on the side that faces toward sun,
**characterized by** the steps:
- applying an aqueous solution of collagen hydrolysate to the glass pane; and
- allowing the aqueous solution to dry.

2. Method in accordance with Claim 1, wherein the solar module is completely or partially transparent, and wherein the solar module preferably comprises solar cells, which are integrated into the glass pane.

3. Method in accordance with Claim 1 or 2, wherein the aqueous solution is spread, sprayed, or poured onto the glass pane.

4. Method in accordance with any one of the preceding Claims, wherein the aqueous solution comprises a proportion of collagen hydrolysate of about 0.5% by weight or more, preferably about 0.7% by weight or more, further preferably about 0.9% by weight or more.

5. Method in accordance with any one of the preceding Claims, wherein the aqueous solution comprises a proportion of collagen hydrolysate of up to 10% by weight, preferably up to about 5% by weight, further preferably up to about 2.5% by weight.

6. Method in accordance with any one of the preceding Claims, wherein the collagen hydrolysate is produced by chemical or enzymatic hydrolysis of collagen-containing starting materials, preferably from skin or bone of vertebrates, in particular from cattle, swine, or sheep.

7. Method in accordance with any one of the preceding Claims, wherein the collagen hydrolysate has an average molecular weight of about 500 to about 25,000 Da, preferably about 1,000 to about 12,000 Da, further preferably about 2,000 to about 6,000 Da.

8. Method in accordance with any one of the preceding Claims, wherein the aqueous solution further comprises one or more surfactants, preferably in a proportion of about 0.5 to about 2.0% by weight.

9. Method in accordance with Claim 8, wherein the surfactant(s) is/are selected from non-ionic, anionic, and amphoteric surfactants.

10. Method in accordance with Claim 8 or 9, wherein the aqueous solution further comprises one or more components that are selected from complexing agents, pH regulators, and preservatives.

11. Method in accordance with any one of the preceding Claims, wherein the method comprises the repeated application and drying of the aqueous solution of collagen hydrolysate on the glass pane, preferably at time intervals of several days to several weeks.

12. Method in accordance with Claim 11, wherein the glass pane is cleaned before each application of the aqueous solution of collagen hydrolysate.

13. Use of collagen hydrolysate for increasing the efficiency of a solar module or a solar collector, wherein the collagen hydrolysate is applied in the form of an aqueous solution to a glass pane of the sole module or solar collector that faces toward the sun and the aqueous solution is then allowed to dry.

## Revendications

1. Procédé d'augmentation de l'efficacité d'un module solaire ou d'un collecteur solaire, dans lequel le module solaire ou le collecteur solaire présente une vitre sur le côté orienté vers le soleil,
**caractérisé par** les étapes :
- d'application d'une solution aqueuse d'hydrolysat de collagène sur la vitre ; et
- de fait de laisser sécher la solution aqueuse.

2. Procédé selon la revendication 1, dans lequel le module solaire est entièrement ou partiellement transparent, et dans lequel le module solaire comprend de préférence des cellules solaires qui sont intégrées dans la vitre.

3. Procédé selon la revendication 1 ou 2, dans lequel la solution aqueuse est étalée, pulvérisée ou versée sur la vitre.

4. Procédé selon l'une quelconque des revendications précédentes, dans lequel la solution aqueuse comprend un pourcentage d'hydrolysat de collagène d'environ 0,5 % en poids ou plus, de préférence d'environ 0,7 % en poids ou plus, de manière davantage préférée d'environ 0,9 % en poids ou plus.

5. Procédé selon l'une quelconque des revendications précédentes, dans lequel la solution aqueuse comprend un pourcentage d'hydrolysat de collagène allant jusqu'à 10 % en poids, de préférence jusqu'à environ 5 % en poids, de manière davantage préférée jusqu'à environ 2,5 % en poids.

6. Procédé selon l'une quelconque des revendications précédentes, dans lequel l'hydrolysat de collagène est fabriqué par hydrolyse chimique ou enzymatique de matières premières animales contenant du collagène, de préférence à partir de la peau ou des os de vertébrés, en particulier de bovins, de porcs ou de moutons.

7. Procédé selon l'une quelconque des revendications précédentes, dans lequel l'hydrolysat de collagène présente un poids moléculaire moyen d'environ 500 à environ 25 000 Da, de préférence d'environ 1 000 à environ 12 000 Da, de manière davantage préférée d'environ 2 000 à environ 6 000 Da.

8. Procédé selon l'une quelconque des revendications précédentes, dans lequel la solution aqueuse comprend en outre un ou plusieurs tensioactifs, de préférence dans un pourcentage d'environ 0,5 à environ 2,0 % en poids.

9. Procédé selon la revendication 8, dans lequel le ou les tensioactifs sont choisis parmi les tensioactifs non ioniques, anioniques et amphotères.

10. Procédé selon la revendication 8 ou 9, dans lequel la solution aqueuse comprend en outre un ou plusieurs composants qui sont choisis parmi les agents complexants, les régulateurs de pH et les conservateurs.

11. Procédé selon l'une quelconque des revendications précédentes, dans lequel le procédé comprend l'application et le séchage répétés de la solution aqueuse d'hydrolysat de collagène sur la vitre, de préférence à intervalles de plusieurs jours à plusieurs semaines.

12. Procédé selon la revendication 11, dans lequel la vitre est nettoyée avant chaque application de la solution aqueuse d'hydrolysat de collagène.

13. Utilisation d'hydrolysat de collagène pour augmenter l'efficacité d'un module solaire ou d'un collecteur solaire, dans laquelle l'hydrolysat de collagène est appliqué sous forme d'une solution aqueuse sur une vitre du module solaire ou du collecteur solaire orientée vers le soleil, puis la solution aqueuse est laissée sécher.
